# EUROPEAN PATENT SPECIFICATION

(11) **EP 0 424 608 B1**
(45) Date of publication and mention of the grant of the patent: **01.12.1993**
(21) Application number: 90110401.8
(22) Date of filing: 01.06.1990
(51) Int. Cl.: H01L 21/76, H01L 21/3105

(54) **Forming wide dielectric filled isolation trenches in semiconductors**
Verfahren zur Herstellung breiter mit Dielektrikum gefüllter Isolationsgraben für Halbleiteranordnungen
Formation de rainures d'isolation larges remplies de diélectrique pour dispositifs semi-conducteurs

(30) Priority: 25.10.1989 US 427153
(43) Date of publication of application: 02.05.1991
(73) Proprietor: International Business Machines Corporation, Armonk, N.Y. 10504 (US)
(72) Inventor: Kerbaugh, Michael L., Burlington, Vermont 05401 (US); Koburger III, Charles W., Essex, Vermont 05452 (US); Machesney, Brian J., Burlington, Vermont 05401 (US)
(74) Representative: Schäfer, Wolfgang, Dipl.-Ing.

(56) References cited:
- EP-A- 0 300 569
- EP-A- 0 341 898
- FR-A- 2 599 892
- US-A- 4 671 970
- IBM T.D.B. vol. 27 N 5 October 1984, p. 3068-3070 (DS)

## Description

This invention relates generally to the manufacture of semiconductor devices. More particularly, the invention relates to a method of forming planarized wide filled trenches in the surface of a semiconductor substrate, especially a silicon wafer, particularly filled with dielectric material, although the invention also can be used to form trenches filled with conductive material.

In the art of large-scale integrated chips, a large number of surface conductors are required for distribution of operating voltages and currents and digital signals between devices. Although surface conductors are insulated from the semiconductor substrate upon which they are formed, a certain amount of capacitive coupling is present between the insulated conductor and the substrate through the insulating material. This capacitive coupling degrades the signal carried by the surface conductors.

While this capacitive coupling can be minimized by increasing the thickness of the dielectric material separating the conductors and the substrate, it is more desirable to recess the dielectric material below the surface of the substrate and maintain the planarity of the substrate rather than add the dielectric material onto the surface of the substrate. This is accomplished by forming shallow trenches in the surface of the substrate, and filling the trenches with dielectric material, normally silicon dioxide. These trenches may be either narrow trenches (i.e., less than about 1 µm in width, and more typically about 0.5 µm) and wide trenches (i.e., those wider than about 1 µm).

It is relatively simple to maintain planarity when forming dielectric filled narrow trenches. However, problems of maintaining planarity with the semiconductor substrate and the dielectric material are presented with wide trenches because of the conformal nature of the deposition of the dielectric and especially silicon dioxide in the wide trenches.

There have been several prior art proposals for solving these problems of forming planarized dielectric filled wide trenches. One such proposal, described in US-A-4 385 975 assigned to the assignee of this invention, utilizes a step in the process of depositing a photoresist material through a mask over the dielectric material contained in the trenches before planarization. The dielectric material is then reactive ion etched (RIE) with the photoresist masking the underlying material from etching, thus resulting in a relatively planer structure. US-A-4 671 970 also utilizes a photoresist as a mask for reactive ion etching of dielectric material. These teachings of masking, while somewhat effective, nevertheless have certain drawbacks. They require extra masking and photolithographic steps, which adds two processing steps, and more importantly create significant problems of alignment; i.e., the mask must be perfectly aligned to deposit the photoresist exactly within the conformal or trough portion of the deposited dielectric material to be utilized to mask just that dielectric material desired and to expose the rest. A corresponding method is disclosed in EP-A-0 300 569.

A similar method for forming dielectric filled isolation trenches in a semiconductor substrate including process steps for planarising the structure is disclosed in FR-A-2 599 892. Again this method does not avoid perfectly aligned masking steps.

US-A-4 278 987 shows a somewhat different technique for filling trenches, not with dielectric material, but with a semiconductor material having a different characteristic than the base substrate material. This also uses a masking process.

One of the principal objects of this invention is to provide an improved method of forming dielectric filled wide trenches in a semiconductor substrate which is self-aligning and has resultant good planarization.

A method or process for forming a wide, shallow filled trench on the surface of a semiconductor substrate is provided, and in particular a dielectric filled trench. The process includes forming a wide, shallow trench in the surface of the semiconductor substrate followed by conformally depositing a layer of dielectric material on the surface of the substrates including in the trench. A layer of etch-resistant material is deposited on the layer of the dielectric material. Portions of the etch resistant material outside the width of the trench are selectively removed, preferably by chemical-mechanical polishing, such that the remaining portions of the etch resistant material reside within the width of the trench. Following this, a dielectric plug is formed above the trench by etching the layer of dielectric material which is not covered by the etch resistant material down to the top of the trench. Finally, the dielectric plug is removed, preferably by polishing, to obtain a dielectric filled trench, having an upper surface in substantial planarity with the upper surface of the substrate. This invention also can be used to fill and planarize trenches with conductive material.

One way of carrying out the invention is described in detail below with reference to drawings which illustrate only one specific embodiment, in which:

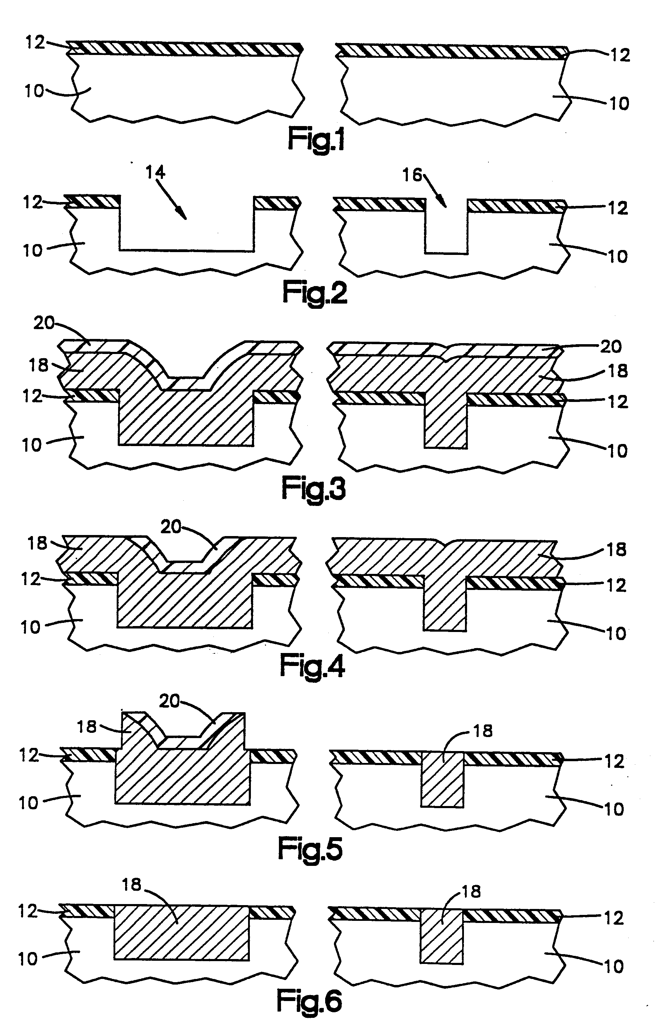

- Fig. 1 through 6: are cross-sectional views, somewhat diagrammatic, showing successive stages of processing of a semiconductor having wide and narrow shallow trenches formed, filled with dielectric material and planarized according to this invention.

Referring now to the drawings, and for the present, Fig. 1, there is shown a silicon semiconductor substrate 10 having an etch stop coating of silicon nitride (Si₃N₄) 12 deposited thereon. The silicon nitride is typically about 100 nm thick and can be deposited by conventional means such as by chemical vapor deposition (CVD) from SiH₂C1₂+NH₃ at 400mTorr, at 770°C. The silicon nitride is then patterned by conventional photoresist techniques to reveal underlying openings where both wide and narrow trenches are to be formed. Two such trenches 14 and 16 are shown in Fig. 2 formed in substrate 10 although it is to be understood that normally many such trenches are formed. The trench 14 is a wide trench, typically wider than about 1 µm, and the trench 16 is a narrow trench, less than 1 µm wide and typically about 0.5 µm wide. These can be formed by conventional RIE etching in a well-known manner, such as, for example, in a plasma of NF₃ + Ar at 10 mTorr and 0.1-0.2 W/cm², utilizing the photoresist as a mask material which is a well-known practice in the art. Other processes, also which are well-known, may be used to form the trenches 14 and 16.

As indicated above, the present invention is especially useful for forming dielectric filled wide trenches; however, Fig.s 1 through 6 illustrate how the present invention can be used on substrates which contain narrow trenches as well as wide trenches.

As shown in Fig. 3, a layer of silicon dioxide (SiO₂) 18 is formed over the surface of the substrate, including both the wide and narrow trenches 14 and 16. Preferably the SiO₂ layer is deposited using wellknown CVD processes which typically includes vapor deposition in tetraethylorthosilane (TEOS) at 650mTorr at 715°C. Of course, other processes could be used. The thickness of the CVD SiO₂ layer is approximately equal to the total depth of the trench so that the top of the SiO₂ layer in the trench 14 is approximately even with the top layer of the silicon substrate. This is typically about 600 nm thickness, although this can vary greatly with different substrates, depending upon the utilization of the substrates for forming devices and the type of conductors which are to be formed on the substrate.

On top of the silicon dioxide layer 18 is formed a thin layer of polysilicon 20 which typically is about 100 nm thick. This polysilicon can be deposited in any conventional manner, a preferred method being CVD in SiH₄+H₂ at 400mTorr at 620°C. This resultant structure is shown in Fig. 3. This structure is then subjected to a chemical-mechanical polish to remove just that portion of the polysilicon 20 which is located outside the confines of the trench 14. In the preferred polishing technique the substrate is mounted onto a flat circular holder which maintains the exposed surface of the polysilicon 20 in contact with a rotating polyurethane pad. The pad is wetted with a slurry of an abrasive material in a basic aqueous solution, such as SiO₂, plus aluminum oxide (A1₂O₃) and tetramethylammonium hydroxide (TMAH). As the polyurethane pad rotates against the surface of the exposed polysilicon, the chemicals react with the very outer-most surface of the polysilicon 20 to loosen it from the polysilicon which underlies it. The mechanical or abrasive action of the SiO₂ then removes this loosened surface wherever it contacts it. Such chemical-mechanical polishing is well-known in the art. This is a continuous process in that a continuous reaction occurs at the outer surface with the chemicals for loosening this layer and those loosened portions of the polysilicon are removed by the abrasive action of the SiO₂.

The chemical-mechanical polishing continues until all of the polysilicon that lies outside of the boundaries of the trench 14 has been removed as shown in Fig. 4. Coincidentally it can be seen that actually all of the polysilicon has been removed from the surface of the dielectric 18, filling the narrow trench 16. This, however, is not a problem because of the narrowness of the trench 16, and there is very little conformality which is indicated by the small indentation shown thereabove and is not significant.

The material shown in Fig. 4 is then anisotropically etched by reactive ion etching (RIE). Typically this can be done in a CHF₃ + CO₂ atmosphere at 0.1-0.2 W/CM² and 40mTorr. This RIE is reactive with the SiO₂ material 18 but is not reactive with the polysilicon material 20. Thus, the SiO₂ material not masked by the polysilicon material 20 is removed with the silicon nitride layer 12 acting as an etch stop in a wellknown manner. This will result in the structure shown in Fig. 5 in which the underlying silicon nitride 12 has been revealed on both sides of the wide trench 14 and on both sides of the narrow trench 16. Also, it should be noted that with respect to the narrow trench 16, since there was no polysilicon material overlying the silicon dioxide in the trench 16, that thc etch was also reacting with the SiO₂ overlying the trcnch 16 to provide a planarized surface of the dielectric material 18 with respect to the silicon nitride 12. However, with respect to the material overlying the wide trench 14, a plug of material is left which comprises the SiO₂ material underlying the polysilicon 20. This plug of material extends significantly above the planarized level of the silicon nitride 12, thus providing essentially a planarized surface over all of the substrate, except over any trenches where there are these plugs of material.

The entire wafer shown in Fig. 5 is then again chemically-mechanically polished using a silica slurry in basic aqueous solution and polished against a rotating polyurethane disk. This polishing step will remove the plugs of material which are above the wide trenches 14 resulting in a final structure shown in Fig. 6. The silicon nitride 12 acts as the end point for the polishing so that the entire surface of the wafer which includes both wide and narrow trenches filled with silicon dioxide are essentially planarized and hence ready for further processing such as the formation of the conductor patterns on the surface.

Several modifications can be made to the process. For example, a thin (50nm) layer of polysilicon can be deposited over the silicon nitride layer 12. This will improve the selectivity of the SiO₂ RIE, making complete removal thereof more feasible without impairing the uniformity of the silicon nitride etch stop. Also a thin (50nm) layer of silicon nitride can be deposited over the SiO₂ layer 18 before the deposition of the polysilicon layer 20. This will help prevent reduction of the SiO₂ layer during the first chemical-mechanical polishing step for the remaining polysilicon layer 20 overlying the trenches 18.

It is also contemplated that similar process steps can be used to form planarized surfaces wherein trenches are filled with conductive materials rather than dielectric materials. In such case, the masking materials and etch reagents and conditions are selected to provide the selectivity required.

## Claims

1. A process for forming a wide filled trench in the surface of a semiconductor substrate comprising the steps of:
a layer of etch stop material (12) on the surface of said substrate (10) at least in the region adjacent said wide trenches (14);
forming a wide trench (14) in the surface of the substrate;
conformally forming a layer of filling material (18) on the surface of the substrate including in said trench (14), the top surface of said layer of filling material (18) extends at least up to the plane of the surface of the substrate and forms a depression above each wide trench (14);
conformally forming a layer of etch resistant material (20) on said layer of filling material (18) which etch resistant material will mask said filling material from reactive ion etching;
selectively removing only those portions of said etch resistant material that extend above the surface of said filling material by chemical-mechanical polishing and not removing any etch resistant material disposed below the surface of said filling material, such that the only remaining portion of the etch resistant material resides within the width of said trench;
forming a plug above said trench by anisotropically reactive ion etching said layer of filling material which is not masked by said etch resisting material down to said layer of etch stop material (12); and
removing said plug by chemical-mechanical polishing to obtain a filled trench having an upper surface in substantial planarity with the upper surface of said layer of etch stop material (12).

2. The process as defined in claim 1, wherein said filling material (18) is a dielectric material comprising silicon dioxide.

3. The process as defined in claim 1 or 2, wherein said etch-resistant material (20) is polysilicon or silicon nitride.

4. The process as defined in one or more of the preceding claims 1 to 3, wherein said etch stop material (12) is silicon nitride.

5. The process of one or more of the preceding claims 1 to 4, wherein the chemical mechanical polishing of said etch-resistant material (20) if being polysilicon is done with a slurry of abrasive material maintained in a basic aqueous solution.

6. The process as defined in one or more of the preceding claims 1, 3, 4 and 5, wherein said filling material (18) is a conductive material.

## Patentansprüche

1. Ein Verfahren zur Herstellung eines breiten gefüllten Grabens in der Oberfläche eines Halbleitersubstrats, wobei das Verfahren folgende Schritte umfaßt:
eine Schicht mit Ätzsperrmaterial (12) auf der Oberfläche des Substrats (10) mindestens im Bereich neben den breiten Graben (14);
die Herstellung eines breiten Grabens (14) in der Oberfläche des Substrats;
die gleichmäßige Bildung einer Schicht von Füllmaterial (18) auf der Oberfläche des Substrats, wobei in dem Graben (14) die Oberfläche der Füllmaterialschicht (18) mindestens bis zur oberen flachen Seite der Substratoberfläche geht und eine Vertiefung über jedem breiten Graben (14) bildet:
die gleichmäßige Bildung einer Schicht von Ätzresistenzmaterial (20) auf der Füllmaterialschicht (18), wobei das Ätzresistenzmaterial das Füllmaterial vor reaktivem Ionenätzen maskiert:
das selektive Entfernen nur des Teiles des Ätzresistenzmaterials, das über die Oberfläche des Füllmaterials hinausgeht, indem ein chemisch-mechanisches Polierverfahren angewendet wird, wobei Ätzresistenzmaterial, das sich unter der Oberfläche des Füllmaterials befindet, nicht entfernt wird, so daß nur der Teil des Ätzresistenzmaterials übrigbleibt, das sich im Graben befindet;
das Bilden eines Stopfens über dem Graben durch anisotropisches reaktives Ionenätzen der Füllmaterialschicht, die nicht durch das Ätzresistenzmaterial bis zur Ätzsperrmaterialschicht maskiert ist; und
das Entfernen des Stopfens durch chemisch-mechanisches Polieren, um einen gefüllten Graben zu erhalten, dessen obere Fläche im wesentlichen planar mit der oberen Fläche der Ätzsperrmaterialschicht (12) ist.

2. Das Verfahren nach Anspruch 1, bei dem das Füllmaterial (18) ein dielektrisches Material ist, das Siliziumoxid umfaßt.

3. Das Verfahren nach Anspruch 1 oder 2, bei dem das Ätzresistenzmaterial (20) ein Polysilizium oder Siliziumnitrid ist.

4. Das Verfahren nach einem oder mehreren der oben genannten Ansprüche 1 bis 3, bei dem das Ätzsperrmaterial (12) Siliziumnitrid ist.

5. Das Verfahren nach einem oder mehreren der oben genannten Ansprüche 1 bis 4, bei dem das chemisch-mechanische Polieren des Ätzresistenzmaterials (20) im Fall von Polysilizium mit einer Emulsion aus Schleifmaterial, das in einer basischen Wasserlösung ist, vorgenommen wird.

6. Das Verfahren nach einem oder mehreren der oben genannten Ansprüche 1, 3, 4 und 5, bei dem das Füllmaterial (18) ein leitendes Material ist.

## Revendications

1. Procédé de formation d'une large tranchée remplie dans la surface d'un substrat semiconducteur comprenant les étapes de:
dépôt d'une couche de matériau d'arrêt d'attaque chimique (12) sur la surface dudit substrat (10) au moins dans la région adjacente auxdites larges tranchées (14);
formation d'une large tranchée (14) dans la surface du substrat;
formation conforme d'une couche de matériau de remplissage (18) sur la surface du substrat y compris dans ladite tranchée (14), la surface supérieure de ladite couche de matériau de remplissage (18) s'étendant au moins jusqu'au plan de la surface du substrat et formant une dépression au-dessus de chaque large tranchée (14);
formation conforme d'une couche de matériau résistant à l'attaque (20) sur ladite couche de matériau de remplissage (18) lequel matériau résistant à l'attaque protégeant ledit matériau de remplissage contre l'attaque des ions réactifs;
retrait sélectif uniquement des parties dudit matériau résistant à l'attaque qui s'étendent au-dessus de la surface dudit matériau de remplissage en polissant chimiquement et mécaniquement sans retirer le matériau résistant à l'attaque disposé au-dessous de la surface dudit matériau de remplissage, de telle sorte que seule la partie restante du matériau résistant à l'attaque se trouve à l'intérieur de la largeur de ladite tranchée;
formation d'une fiche au-dessus de ladite tranchée par attaque avec des ions réactifs anisotropiquement de ladite couche de matériau de remplissage qui n'est pas masquée par ledit matériau résistant à l'attaque en descendant vers ladite couche de matériau d'arrêt d'attaque; et
retrait de ladite fiche par polissage chimique et mécanique pour obtenir une tranchée remplie ayant une surface supérieure sensiblement dans le même plan que la surface supérieure de ladite couche (12) de matériau d'arrêt d'attaque.

2. Procédé selon la revendication 1, dans lequel ledit matériau de remplissage (18) est un matériau diélectrique comprenant du dioxyde de silicium.

3. Procédé selon la revendication 1 ou 2, dans lequel ledit matériau (20) résistant à l'attaque est du polysilicium ou du nitrure de silicium.

4. Procédé selon l'une ou plusieurs des revendications précédentes 1 à 3, dans lequel ledit matériau (12) d'arrêt d'attaque est du nitrure de silicium.

5. Procédé selon l'une ou plusieurs des revendications précédentes 1 à 4, dans lequel le polissage chimique et mécanique dudit matériau (20) résistant à l'attaque, s'il s'agit de polysilicium, est réalisé par une pâte de matériau abrasif maintenue dans une solution aqueuse basique.

6. Procédé selon une ou plusieurs des revendications précédentes 1, 3, 4 et 5, dans lequel ledit matériau de remplissage (18) est un matériau conducteur.
